(19) Europäisches Patentamt
European Patent Office
Office européen des brevets

(11) Veröffentlichungsnummer: **0 230 941 B1**

(12) # EUROPÄISCHE PATENTSCHRIFT

(45) Veröffentlichungstag der Patentschrift: **09.09.92**

(51) Int. Cl.[5]: **G03F 7/00**

(21) Anmeldenummer: **87100590.6**

(22) Anmeldetag: **17.01.87**

(54) **Photopolymerisierbares Gemisch und dieses enthaltendes photopolymerisierbares Aufzeichnungsmaterial.**

(30) Priorität: **25.01.86 DE 3602215**

(43) Veröffentlichungstag der Anmeldung:
**05.08.87 Patentblatt 87/32**

(45) Bekanntmachung des Hinweises auf die Patenterteilung:
**09.09.92 Patentblatt 92/37**

(84) Benannte Vertragsstaaten:
**DE FR GB IT**

(56) Entgegenhaltungen:
**EP-A- 0 071 789**
**DE-A- 1 929 375**
**GB-A- 1 154 716**
**GB-A- 1 205 781**

**PATENT ABSTRACTS OF JAPAN, Band 8, Nr. 175 (P-294)[1612], 11. August 1984; & JP-A-59 69 752 (SEKISUI KAGAKU KOGYO K.K.) 20-04-1984**

(73) Patentinhaber: **HOECHST AKTIENGESELL-SCHAFT**
**Postfach 80 03 20**
**W-6230 Frankfurt am Main 80(DE)**

(72) Erfinder: **Frommeld, Hans-Dieter, Dr.**
**Simrockstrasse 7A**
**W-6200 Wiesbaden(DE)**

EP 0 230 941 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein photopolymerisierbares Gemisch, das als wesentliche Bestandteile ein polymeres Bindemittel, eine ethylenisch ungesättigte polymerisierbare Verbindung und einen Photoinitiator enthält.

Gemische dieser Art dienen zur Herstellung von Druckplatten, Reliefbildern und Photoresists und sind z. B. aus den DE-C 1 171 267, 2 027 467 und 2 039 861 sowie den DE-A 15 22 515, 20 64 079 und 20 64 080 (= US-A 3 804 631) bekannt. Besondere Bedeutung haben sie als Aufzeichnungsmaterialien für die photomechanische Herstellung von Flachdruckformen und für die Photoresisttechnik.

Derartige Gemische oder Materialien enthalten in der photopolymerisierbaren Schicht normalerweise Farbstoffe oder Pigmente, um das Reliefbild nach dem Entwickeln besser sichtbar zu machen. Die farbigen Zusätze sollen naturgemäß lichtecht sein, da die nach dem Entwickeln verbleibende Bildschablone, die aus den lichtgehärteten Schichtteilen besteht, möglichst kontrastreich bleiben soll.

Andererseits wird auch gefordert, daß sich unmittelbar nach dem Belichten von photopolymerisierbaren Aufzeichnungsmaterialien die belichteten von den unbelichteten Flächen deutlich unterscheiden. Hierzu werden u. a. Azofarbstoffe eingesetzt, die beim Belichten ausgebleicht werden. Allerdings werden mit diesen Farbstoffen zumeist nur helle, d. h. kontrastarme Bilder erzeugt.

Bestimmte Azofarbstoffe, die reversibel gebleicht werden, werden in der DE-A 28 07 933 beschrieben. Sie werden bei Belichtung bis zu 50 % der ursprünglichen Extinktion ausgebleicht und ergeben dadurch einen relativ guten Bildkontrast. Allerdings muß sofort nach dem Belichten entwickelt werden, da sich insbesondere unter Zutritt von Luftsauerstoff die ursprüngliche Farbdichte allmählich regeneriert und daher der Belichtungskontrast verschwindet.

Nach der EP-A 24 916 können Triarylmethanfarbstoffe, cis- oder trans-Azobenzole, Thioindigofarbstoffe, o-Nitrobenzolderivate sowie Spiropyranverbindungen, die photochrome Eigenschaften in positiv arbeitenden Photoresists aufweisen, verwendet werden.

In der DE-A 31 31 448 sind photopolymerisierbare Gemische mit Amino- oder Iminogruppen enthaltenden Bindemitteln beschrieben, die als Zusätze Farbstoffe, Kontrastmittel oder photochrome Verbindungen enthalten können. Als photochrome Verbindungen werden Leukofarbstoffe, z. B. Leukokristallviolett, genannt. Als geeignete Kontrastfarbstoffe werden u. a. Triphenylmethanfarbstoffe und das 3'-Phenyl-7-dimethylamino-2,2'-spirodi[2H-1-benzopyran] erwähnt.

Aufgabe der Erfindung war es, photopolymerisierbare Gemische hoher Lichtempfindlichkeit vorzuschlagen, die unmittelbar nach dem Belichten einen starken Bildkontrast aufweisen und diesen auch bei längerer Lagerung beibehalten. Ein guter Kontrast sollte auch nach dem Entwickeln zwischen den belichteten Schichtbereichen und dem Schichtträger, insbesondere solchen aus Kupfer, erkennbar sein. Die Gemische sollten ferner als photopolymerisierbare Schichten auf Kupfer enthaltenden Schichtträgern wenigstens zwei Wochen ohne wesentliche Veränderung lagerfähig sein.

Erfindungsgemäß wird ein photopolymerisierbares Gemisch vorgeschlagen, das als wesentliche Bestandteile

a) ein polymeres Bindemittel,
b) eine Verbindung mit mindestens einer endständigen ethylenischen Doppelbindung und einem Siedepunkt bei Normaldruck oberhalb 100° C, die durch radikalisch initiierte Polymerisation ein Polymeres zu bilden vermag,
c) einen Photoinitiator und
d) die Leukobase eines Triarylmethanfarbstoffs

enthält.

Das erfindungsgemäße Gemisch ist dadurch gekennzeichnet, daß es zusätzlich ein photochromes Spiro-indolino-benzopyran der allgemeinen Formel I

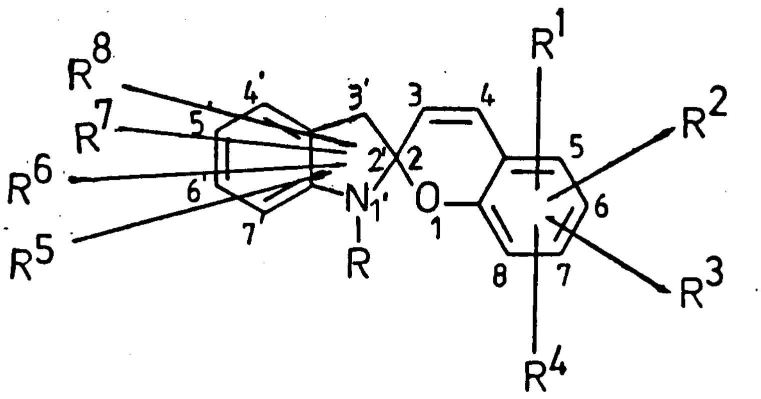

(I)

enthält, worin

| | |
|---|---|
| R | ein Wasserstoffatom oder einen Alkylrest mit 1 bis 16 C-Atomen, |
| $R^1$, $R^2$, $R^3$ und $R^4$ | gleich oder verschieden sind und Wasserstoff- oder Halogenatome, Alkyl- oder Alkoxygruppen mit 1 bis 4 C-Atomen oder Nitrogruppen, |
| $R^5$, $R^6$, $R^7$ und $R^8$ | gleich oder verschieden sind und Wasserstoff- oder Halogenatome, Nitro-, Aminogruppen, Alkyl- oder Alkoxygruppen mit 1 bis 5-C-Atomen oder Arylgruppen mit 6 bis 10 C-Atomen |

bedeuten.

Geeignete Leukobasen von Triarylmethanfarbstoffen sind u. a. diejenigen von Kristallviolett, Victoriablau BH, Victoriareinblau BOH, Methylviolett, Fuchsin, Malachitgrün, Acid Violet 5B, Solar Cyanine 6B, Brilliantgrün und Acilanviolett S.

Von den Spiro-[2H-1-benzopyran-2,2′-indolinen] der Formel I können in den erfindungsgemäßen photopolymerisierbaren Gemischen sowohl Derivate, die am Benzopyranringsystem als auch solche, die am Indolinsystem substituiert sind, Anwendung finden.

Geeignete substituierte Benzopyrane sind:
6-Acetyl-, 5-Brom-8-methoxy-6-nitro-, 5-Brom-6-nitro-, 6-Brom-8-nitro-, 8-Brom-6-nitro-, 6-Chlor-, 7-Chlor-, 6-Chlor-5,7-dimethyl-8-nitro-, 8-Chlor-5,6-dinitro-, 5-Chlor-6-nitro-, 5-Chlor-8-nitro-, 6-Cyano-, 5,7-Dichlor-6-nitro-, 6,8-Dichlor-5-nitro-, 5,7-Dimethoxy-6-nitro-, 8-Fluor-, 6-Fluor-8-nitro-, 8-Fluor-6-nitro-, 7-Hydroxy-, 6-Iod-8-nitro-, 8-Iod-6-nitro-, 7-Methoxy-5-methyl-6-nitro-,6-Methoxy-5-nitro-, 8-Methoxy-5-nitro-, 8-Methoxy-6-nitro-, 5-Nitro-, 6-Nitro-, 7-Nitro-, 8-Nitro-, 6-Nitro-5,7,8-trimethyl-, 6-(β-Nitrovinyl)- und 7-Methyl-benzopyran.

Als substituierte Indoline kommen die folgenden Verbindungen in Frage:
1′-Butyl-, 3′,3′-Diethyl-, 3′,3′-Diphenyl-, 3′,7′-Diphenyl-, 3′-Ethyl-, 1′-Hexadecyl-, 1′-Isoamyl-,5′-Nitro-3′-phenyl-, 3′-Phenyl-, 1′,3′,3′-Trimethyl-, 4′-Chlor-, 5′-Chlor-, 6′-Chlor-, 5′,7′-Dichlor-, 1′,3′,3′-Trimethyl-5′-chlor-, 4′,6′-Dimethoxy-, 4′,7′-Dimethyl-, 5′,7′-Dimethyl-, 4′,6′-Diphenyl-, 5′,7′-Diphenyl-, 4′-Fluor-, 5′-Fluor-, 5′-(β-Hydroxyethyl), 5′-Methoxy-, 7′-Methoxy-, 5′-Methyl-, 6′-Methyl-, 7′-Methyl-, 5′-Nitro-, 7′-Nitro-, 5′-Phenyl-, 7′-Phenyl- und 4′,6′,7′-Triphenyl-indolin.

Wenn einer oder mehrere der Reste $R^1$ bis $R^8$ Alkylgruppen sind, haben diese bevorzugt 1 oder 2 Kohlenstoffatome; Methylgruppen werden besonders bevorzugt. R ist bevorzugt eine Alkylgruppe, insbesondere eine mit 1 bis 5 Kohlenstoffatomen, wobei die Methylgruppe besonders bevorzugt ist.

Verbindungen der Formel I, die mindestens eine Nitrogruppe enthalten, die insbesondere im Benzopyransystem steht, geben besonders starke Farbkontraste und werden daher bevorzugt.

Zu den geeigneten Spiro-[2H-1-benzopyran-2,2′-indolinen] zählen vorzugsweise solche, die - entsprechend den oben zusammengestellten, grundsätzlich möglichen Substituenten -an beiden Ringsystemen substituiert sind. Besonders hervorzuheben sind die substituierten Verbindungen, die am Indolinsystem in den Positionen 1′ einmal und 3′ zweimal durch Methylgruppen sowie in Position 6 am Benzopyransystem durch eine Nitrogruppe und ggf. zusätzlich in Position 8 durch eine Alkoxygruppe, insbesondere eine Methoxygruppe, substituiert sind.

Weitere geeignete Spiro-indolino-benzopyrane sind in dem Buch "Photochromism" von G. H. Brown, Wiley-Interscience, New York (1971), S. 165-169, insbesondere S. 169 beschrieben.

Der Gehalt des photopolymerisierbaren Gemischs, bezogen auf seine nichtflüchtigen Bestandteile, an Leukobase beträgt 0,05 bis 5, vorzugsweise 0,4 bis 4 Gew.-%. Der entsprechende Gehalt an Spiroverbindung beträgt im allgemeinen 0,01 bis 2, vorzugsweise 0,05 bis 1 Gew.-%. Das Mengenverhältnis zwischen Leukobase und Spiroverbindung liegt vorzugsweise zwischen 12:1 und 2:1.

Als Photopolymerisationsinitiatoren können in dem erfindungsgemäßen Gemisch eine Vielzahl von Substanzen Verwendung finden. Beispiele sind Benzophenon, Thioxanthon und Benzoin sowie ihre Derivate.

Bevorzugt werden Heterocyclen mit 2 bis 5 anellierten Ringen und mindestens einem Stickstoffatom als Heteroatom, insbesondere Acridinderivate, z. B. 9-Phenylacridin, 9-p-Methoxy-phenyl-acridin, 9-Acetylaminoacridin, Benz(a)acridin; Chinolinderivate, z. B. 2-Styrylchinolin, Cinnamylidenchinaldin; Phenazinderivate, z. B. 9,10-Dimethyl-benz(a)phenazin, 10-Methoxy-benz(a)phenazin; Chinoxalinderivate, z. B. 6,4′,4″-Trimethoxy-2,3-diphenylchinoxalin, 4′,4″-Dimethoxy-2,3-diphenyl-5-azachinoxalin oder Chinazolinderivate. Diese bevorzugten Initiatoren sind in den DE-C 20 27 467 und 20 39 861 sowie in der älteren Patentanmeldung P 35 37 380 beschrieben.

Die Initiatoren werden allgemein in einer Menge von 0,01 bis 10, vorzugsweise von 0,05 bis 4 Gew.-%, bezogen auf die nicht flüchtigen Bestandteile des Gemisches, eingesetzt.

Für die Zwecke der Erfindung geeignete polymerisierbare Verbindungen sind bekannt und z. B. in den US-A 2 760 863 und 3 060 023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079, 23 61 041 und 28 22 190 beschrieben.

Der Mengenanteil der Schicht an Monomeren beträgt im allgemeinen etwa 10 bis 80, vorzugsweise 20 bis 60 Gew.-%.

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine und Celluloseether.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure- und Styrol/MaleinsäureanhydridMischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 40 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind:
Inhibitoren zur Verhinderung der thermischen Polymerisasation der Monomeren,
Wasserstoffdonatoren,
die sensitometrischen Eigenschaften derartiger Schichten modifizierende Stoffe,
Farbstoffe,
gefärbte und ungefärbte Pigmente,
Weichmacher, z.B. Polyglykole oder Ester der p-Hydroxybenzoesäure.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des kurzwelligen sichtbaren Lichts entspricht. Geeignet ist langwellige UV-Strahlung, aber auch Laserstrahlung.

Das photopolymerisierbare Gemisch kann für die verschiedensten Anwendungen Einsatz finden, beispielsweise zur Herstellung von Lacken, die durch Licht gehärtet werden, und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den

Flachdruck, den Tiefdruck, den Siebdruck, von Reliefkopien, z.B. Herstellung von Texten in Blindenschrift, von Einzelkopien, Gerbbildern, Pigmentbildern usw.. Weiter sind die Gemische zur photomechanischen Herstellung von Ätzreservagen, z.B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Flachdruckformen und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen, Ebenso ist es für die Herstellung von Trockenresist geeignet.

Es ist im allgemeinen günstig, die Gemische während der Lichtpolymerisation dem Einfluß des Luftsauerstoffes weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z.B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z.B. Wachse, Polyvinylalkohol, Polyphosphate, Zucker usw..

Als Schichtträger für mit dem erfindungsgemäßen Gemisch hergestellte Kopiermaterialien sind beispielsweise Aluminium, Stahl, Zink, Kupfer und Kunststoff-Folien, z.B. aus Polyethylenterephthalat oder Cellulosacetat, sowie Siebdruckträger, wie Perlongaze, geeignet.

Die Herstellung der lichtempfindlichen Materialien unter Verwendung des erfindungsgemäßen Gemischs erfolgt in bekannter Weise.

So kann man dieses in einem Lösungsmittel aufnehmen und die Lösung bzw. Dispersion durch Gießen, Sprühen, Tauchen, Antrag mit Walzen usw. auf den vorgesehenen Träger als Film antragen und anschließend antrocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und angetrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Die Verarbeitung der Materialien wird in bekannter Weise vorgenommen. Zur Entwicklung werden sie mit einer geeigneten Entwicklerlösung, z.B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Die erfindungsgemäßen Materialien ergeben unmittelbar bei der Bildbelichtung einen deutlich sichtbaren Farbkontrast durch intensive Färbung der belichteten Stellen. Der Farbkontrast ändert sich beim Liegen im Dunklen praktisch nicht und bleibt über Tage und Wochen erhalten. Dabei wird die Lichtempfindlichkeit des photopolymerisierbaren Gemischs durch die kontrastbildenden Zusätze praktisch nicht beeinflußt.

Überraschenderweise ergeben nur die Spiroverbindungen der Formel I in dem erfindungsgemäßen Gemisch die gewünschte Wirkung, während das in der DE-A 31 31 448 als Farbstoff erwähnte strukturell sehr ähnliche 3′-Phenyl-7-dimethylamino-2,2′-spirodi[2H-1-benzopyran] weder allein noch in Kombination mit einem Leuko-triarylmethanfarbstoff in diesem Gemisch eine photochrome Verfärbung erleidet. Wenn allerdings eine Verbindung der Formel I allein ohne Zusatz einer Leukobase eingesetzt wird, nimmt diese Färbung nach Beendigung der Bildbelichtung rasch wieder ab und ist nach einigen Stunden praktisch verschwunden.

Wenn die Leukobase allein zugesetzt wird, ergibt sie in dem erfindungsgemäßen Gemisch unmittelbar nach der Belichtung noch praktisch keinen Bildkontrast. Erst nach längerer Lagerung im Dunklen wird ein deutlicher Bildkontrast sichtbar, der nach etwa einem Tag sein Maximum erreicht.

Die folgenden Beispiele erläutern bevorzugte Ausführungsformen der Erfindung. Mengenverhältnisse und Prozentzahlen sind in Gewichtseinheiten zu verstehen, wenn nichts anderes angegeben ist. Die Mengen an Bestandteilen sind in der Regel in Gewichtsteilen (Gt) angegeben.

Beispiel 1

Die folgenden Lösungen 1a bis 1f wurden hergestellt, indem jeweils einer Grundlösung aus

| | |
|---|---|
| 20 Gt | des Umsetzungsproduktes aus 1 mol 2,2,4-Trimethyl-hexamethylendiisocyanat und 2 mol 2-Hydroxy-ethylmethacrylat, |
| 20 Gt | eines Terpolymerisats aus Styrol, n-Hexyl-methacrylat und Methacrylsäure (10:60:30) mit der Säurezahl 190, |
| 0,02 Gt | 1,4-Bis-(4-tert.butoxy-phenylamino)-5,8-dihydroxyanthrachinon sowie |
| 0,2 Gt | 9-Phenylacridin in |
| 46 Gt | Butanon und |
| 23 Gt | Ethanol |

die folgenden Bestandteile zugesetzt wurden:

Lösung

| | |
|---|---|
| 1a (V): | kein Zusatz |
| 1b (V): | 0,04 Gt 3′-Phenyl-7-dimethylamino-2,2′-spirodi[2H-1-benzopyran], |
| 1c (V): | 0,04 Gt 1′,3′,3′-Trimethyl-6-nitro-8-methoxy-spiro-[2H-1-benzopyran-2,2′-indolin], |
| 1d (V): | 0,35 Gt Leukokristallviolett, |
| 1e (V): | 0,35 Gt Leukokristallviolett und 0,04 Gt 3′-Phenyl-7-dimethylamino-2,2′-spirodi-[2H-1-benzopyran], |
| 1f : | 0,35 Gt Leukokristallviolett und 0,04 Gt 1′,3′,3′-Trimethyl-6-nitro-8-methoxy-spiro-[2H-1-benzopyran2,2′-indolin]. |

V = Vergleich

Die Lösungen wurden jeweils auf 25µm starke Polyethylenterephthalatfolie aufgebracht. Anschließend wurde 2 Minuten bei 100° C im Trockenschrank getrocknet. Man erhielt 50 g/m$^2$ dicke Trockenresistschichten.

Um die Trockenresistschichten vor Verschmutzung durch Staub und Beschädigungen zu schützen, wurden sie mit einer 20 µm starken Deckfolie aus Polyethylen abgedeckt, die an der Schicht weniger stark haftet als die Polyesterfolie. Die erhaltenen Materialien können über einen längeren Zeitraum unter Lichtausschluß gelagert werden.

Nach Abziehen der Deckfolie wurde die Trockenresistschicht mit Hilfe eines handelsüblichen Laminators bei 120° C und mit einer Geschwindigkeit von 1,5 m/Minute auf eine vorgereinigte Kupferfolie, die mit einem Epoxid-Glasfaser-Hartgewebe kaschiert ist, auflaminiert.

Die Proben 1a bis 1f des auf die Kupferoberfläche laminierten Resists wurden anschließend durch die Trägerfolie hindurch unter einer Vorlage belichtet, die je ein transparentes Feld von 4 × 4 cm, ein Dunkelfeld von 4 × 4 cm, ein Linienmuster sowie einen 13-stufigen Belichtungskeil mit Dichteinkrementen von 0,15 enthielt. Belichtet wurde mit einer eisendotierten 5-kW-Metallhalogenidlampe in einem Abstand von 90 cm jeweils 5 Sekunden.

Mit einem Hunterlab-Farbmeßgerät wurden dann die Helligkeiten der 4 × 4 cm großen Felder gemessen, d. h. das von diesen Feldern remittierte Licht. Der L-Wert ist ein Maß für die Helligkeit (100 = ideales Weiß, O = ideales Schwarz). Die L-Werte sind für die verschiedenen Gemische in Tabelle 1 zusammengestellt.

Tabelle 1

Gemessene L-Werte der Schichten a bis f in Abhängigkeit von der Zeit nach der Belichtung

| Zeit nach der Belichtung (Stunden) | 0 | 0,5 | 1 | 4 | 20 |
|---|---|---|---|---|---|
| a unbelichtet | 60,5 | 60,5 | 60,4 | 60,4 | 60,5 |
| a belichtet | 60,5 | 60,5 | 60,5 | 60,4 | 60,4 |
| b unbelichtet | 60,1 | 60,1 | 60,0 | 60,1 | 60,1 |
| b belichtet | 60,0 | 60,1 | 60,1 | 60,0 | 60,0 |
| c unbelichtet | 59,1 | 59,1 | 59,0 | 59,0 | 59,0 |
| c belichtet | 54,0 | 54,6 | 55,1 | 56,4 | 58,8 |
| d unbelichtet | 56,3 | 56,2 | 56,0 | 55,9 | 55,5 |
| d belichtet | 56,0 | 55,1 | 54,2 | 52,3 | 50,4 |
| e unbelichtet | 56,2 | 56,1 | 55,9 | 55,8 | 55,5 |
| e belichtet | 56,2 | 55,1 | 54,0 | 52,2 | 50,2 |
| f unbelichtet | 55,2 | 55,1 | 55,0 | 54,8 | 54,7 |
| f belichtet | 49,9 | 49,8 | 49,6 | 49,4 | 49,2 |

Folgerungen:

1b: Die Vergleichsverbindung 1 b (3′-Phenyl-7-dimethylamino-2,2′-spirodi-[2H-1-benzopyran]) ist sowohl allein (Fig. 1) als auch in Kombination mit der Leukobase (1e) unwirksam.

1c: Die Verbindung 1c (1′,3′,3′-Trimethyl-6-nitro-8-methoxy-spiro-[2H-1-benzopyran-2,2′-indolin]) gibt unmittelbar nach der Belichtung einen guten Kontrast, der aber wieder ausbleicht (Fig. 2).

1d: Leukokristallviolett allein erfordert mehrere Stunden, um einen nennenswerten Kontrast zu erzielen (Fig. 3).

1f: Das erfindungsgemäße Gemisch ergibt einen etwa gleichbleibenden Kontrast, unabhängig von der Zeit (Fig. 4).

Je eine weitere Platte 1a bis 1f wurde wie oben angegeben belichtet und nach Abziehen der Trägerfolie einer Sprühentwicklung mit 0,8 %iger Sodalösung bei 25° C unterworfen. Die Entwicklungszeit betrug ca. 60 Sekunden.

Die Lichtempfindlichkeit hatte sich durch die Zusätze nicht geändert. Bei allen 6 Proben sind die Stufen 1 bis 4 unter dem Halbtonstufenkeil voll ausgehärtet, die Stufen 7 bis 12 vollständig entwickelt. Der Kontrast

zum Kupfer ist bei der erfindungsgemäßen Probe 1f am besten.

Beispiel 2

Beschichtungslösungen aus

| | |
|---|---|
| 100 Gt | Trimethylolpropantriacrylat, |
| 100 Gt | eines Terpolymerisats aus n-Hexylmethacrylat, N-Butoxymethyl-methacrylamid und Methacrylsäure (50:25:25) mit der Säurezahl 163, |
| 1200 Gt | 2-Methoxyethanol, |
| 200 Gt | Butanon und |
| 1 Gt | 3-Benzyliden-9-methyl-2,3-dihydro-1H-cyclopenta[b]chinolin sowie entweder |
| a)(V) 2 Gt | 3′-Phenyl-7-dimethylamino-2,2′-spirodi-[2H-1-benzopyran] oder |
| b)(V) 2 Gt | 1′,3′,3′-Trimethyl-6-nitro-8-methoxy-spiro[2H-1-benzopyran-2,2′-indolin] oder |
| c)(V) 6 Gt | Leukokristallviolett oder |
| d) 6 Gt | Leukokristallviolett + |
| 2 Gt | 1′,3′,3′-Trimethyl-6-nitro-8-methoxy-spiro[2H-1-benzopyran-2,2′-indolin] |

wurden auf elektrolytisch aufgerauhtes und anodisch oxydiertes 0,3 mm starkes Aluminium durch Aufschleudern in der Weise aufgetragen und anschließend 2 Minuten bei 100° C getrocknet, daß ein Schichtgewicht von 2,4 g/m$^2$ erhalten wurde.

Die lichtempfindlichen Platten wurden dann mit einer 15%igen wäßrigen Lösung von Polyvinylalkohol (12 % Restacetylgruppen, K-Wert 4) beschichtet und erneut getrocknet (Schichtgewicht 4 - 5 g/m$^2$).

Die erhaltenen Druckplatten wurden mittels einer 5 kW-Metallhalogenidlampe im Abstand von 110 cm unter einer gerasterten Vorlage 10 Sekunden belichtet. Der entstandene Kontrast vor dem Entwickeln wurde beurteilt.

Beurteilung des Bildkontrastes nach der Belichtung und vor dem Entwickeln:

| | sofort | nach 20 Minuten | nach 24 Stunden |
|---|---|---|---|
| a) | kein Bild | kein Bild | kein Bild |
| b) | gutes Bild | gutes Bild | schwaches Bild |
| c) | kein Bild | brauchbares Bild | brauchbares Bild |
| d) | gutes Bild | gutes Bild | brauchbares Bild |

Werden die Druckplatten sofort nach dem Belichten mit einem Entwickler aus

| | |
|---|---|
| 15 Gt | Pelargonsäure, |
| 10 Gt | Natriumhydroxid, |
| 92 Gt | eines Blockpolymerisats aus 90 % Propylenoxid und 10 % Ethylenoxid, |
| 12 Gt | Natriumtetrapolyphosphat und |
| 550 Gt | Wasser |

behandelt, so zeigen das erfindungsgemäße Muster d) ein kontrastreiches Bild, die Vergleichsmuster c) und b) jeweils ein Bild mit schwachem Kontrast sowie das Vergleichsmuster a) keinen Kontrast, sondern lediglich ein Feld, in dem belichtete und unbelichtete Bereiche durch geringfügige Unterschiede im Oberflächenglanz zu erkennen sind.

Beispiel 3

Beschichtungslösungen aus

| | |
|---|---|
| 30 Gt | des Umsetzungsproduktes aus 1 mol 2,2,4-Trimethyl-hexamethylendiisocyanat und 2 mol 2-Hydroxy-ethylmethacrylat, |
| 10 Gt | Polyethylenglykoldimethacrylat (Mittleres Molgewicht des Polyethylenglykols 550), |
| 60 Gt | eines Terpolymerisats aus Methylmethacrylat, n-Hexylmethacrylat und Methacrylsäure (10:60:30) mit der Säurezahl 190 und |
| 1 Gt | 9-Acetylamino-acridin in |
| 60 Gt | Ethanol und |
| 125 Gt | Butanon |

wurden entweder

| a) ohne Zusatz verwendet oder | |
|---|---|
| b) mit 2 Gt | Leukomalachitgrün oder |
| c) mit 1 Gt | 1′,3′,3′-Trimethyl-6-nitro-spiro[2H-1-benzopyran-2,2′-indolin] oder |
| d) mit 2 Gt | Leukomalachitgrün und |
| 1 Gt | 1′,3′,3′-Trimethyl-6-nitro-spiro[2H-1-benzopyran-2,2′-indolin] oder |
| e) mit 2 Gt | Leukomalachitgrün und |
| 0,5 Gt | 1′,3′,3′-Trimethyl-6-nitro-8-methoxy-spiro[2H-1-benzopyran-2,2′-indolin] |

versetzt und auf 25 µm starke Polyethylenterephthalatfolie aufgebracht und getrocknet (Schichtgewicht trocken 45 g/m$^2$).

Die Trockenresistschichten wurden auf vorgereinigte Kupferfolie, die auf Epoxid-Glasfaser-Hartgewebe kaschiert war, auflaminiert und dann unter einer Vorlage belichtet (5 kW-Metallhalogenidlampe, Abstand 90 cm, 10 Sekunden).

Anschließend wurden die bildmäßig belichteten Flächen beurteilt. Die folgende Tabelle zeigt die Ergebnisse:

| sofort nach dem Belichten | nach 60 Minuten | nach 24 Stunden |
|---|---|---|
| a) kein Bild | kein Bild | kein Bild |
| b) kein Bild | sehr schwaches Bild | brauchbares Bild |
| c) brauchbares Bild | schwaches Bild | sehr schwaches Bild |
| d) brauchbares Bild | brauchbares Bild | brauchbares Bild |
| e) gutes Bild | gutes Bild | brauchbares Bild |

Die belichteten Platten 3a - e ließen sich problemlos mit 0,8 %iger Sodalösung entwickeln und die freigelegten Kupferflächen galvanisch verstärken.

Beispiel 4

Eine Beschichtung aus

| | |
|---|---|
| 40 Gt | eines Copolymerisats aus Methylmethacrylat und Methacrylsäure (Säurezahl 115), |
| 40 Gt | 1,1,1-Trimethylolethantriacrylat, |
| 1 Gt | 6,4′,4″-Trimethoxy-2,3-diphenylchinoxalin, |
| 2 Gt | Leukokristallviolett, |
| 0,5 Gt | 1′,3′,3′-Trimethyl-5′-chlor-6-nitro-8-methoxy-spiro[2H-1-benzopyran-2,2′-indolin] und |
| 520 Gt | 2-Methoxyethanol |

wurde auf eine elektrolytisch aufgerauhte und anodisierte Aluminiumfolie aufgebracht (Trockengewicht 3,4 $g/m^2$). Anschließend wurde die Platte mit einer Deckschicht aus Polyvinylalkohol (4 $g/m^2$) versehen.

Die so hergestellte Druckplatte wurde unter einer Vorlage mit einer 5 kW Metallhalogenidlampe 30 Sekunden belichtet und schließlich mit einem Entwickler aus

| | |
|---|---|
| 15 Gt | Natriummetasilikat × 9 $H_2O$, |
| 3 Gt | Polyglykol 6000, |
| 0,6 Gt | Lävulinsäure und |
| 0,3 Gt | Strontiumhydroxid × 8 $H_2O$ in |
| 1000 Gt | Wasser |

eine Minute überwischt, wobei die unbelichteten Schichtbereiche entfernt wurden.

Vor und nach dem Entwickeln war ein scharfes kontrastreiches negatives Abbild der Druckvorlage zu erkennen.

Anschließend wurde mit schwarzer Fettfarbe eingefärbt. Ein Druckversuch wurde nach 100.000 einwandfreien Drucken abgebrochen.

**Patentansprüche**

**1.** Photopolymerisierbares Gemisch, das als wesentliche Bestandteile

a) ein polymeres Bindemittel,

b) eine Verbindung mit mindestens einer endständigen ethylenischen Doppelbindung und einem Siedepunkt bei Normaldruck oberhalb 100° C, die durch radikalisch initiierte Polymerisation ein Polymeres zu bilden vermag,

c) einen Photoinitiator und

d) die Leukobase eines Triarylmethanfarbstoffs

enthält, dadurch gekennzeichnet, daß es zusätzlich ein photochromes Spiro-indolino-benzopyran der allgemeinen Formel I

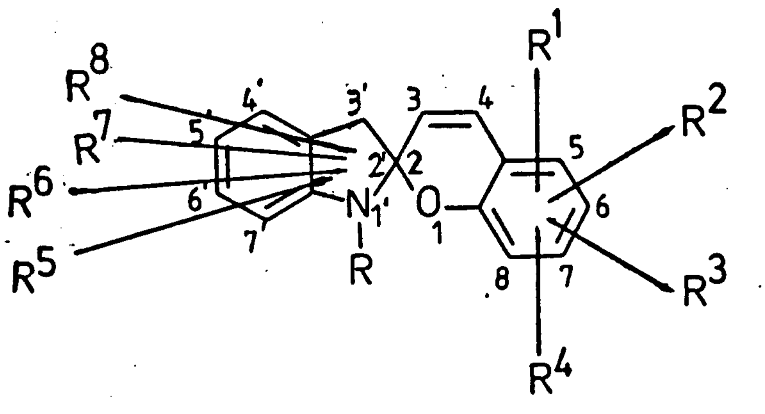

(I)

enthält, worin

| | |
|---|---|
| R | ein Wasserstoffatom oder einen Alkylrest mit 1 bis 16 C-Atomen, |
| $R^1$, $R^2$, $R^3$ und $R^4$ | gleich oder verschieden sind und Wasserstoff- oder Halogenatome, Alkyl- oder Alkoxygruppen mit 1 bis 4 C-Atomen oder Nitrogruppen, |
| $R^5$, $R^6$, $R^7$ und $R^8$ | gleich oder verschieden sind und Wasserstoff- oder Halogenatome, Nitro-, Amino-gruppen, Alkyl- oder Alkoxygruppen mit 1 bis 5-C-Atomen oder Aryl- |

gruppen mit 6 bis 10 C-Atomen

bedeuten.

**2.** Photopolymerisierbares Gemisch nach Anspruch 1, dadurch gekennzeichnet, daß es eine Verbindung der Formel I enthält, worin mindestens einer der Reste $R^1$, $R^2$, $R^3$ und $R^4$ eine Nitrogruppe ist.

**3.** Photopolymerisierbares Gemisch nach Anspruch 1, dadurch gekennzeichnet, daß es eine Verbindung der Formel I enthält, worin drei der Reste $R^5$, $R^6$, $R^7$ und $R^8$ Methylgruppen sind.

**4.** Photopolymerisierbares Gemisch nach Anspruch 1, dadurch gekennzeichnet, daß die Leukobase ein Tris-(4-dialkylamino-phenyl)methan ist.

**5.** Photopolymerisierbares Gemisch nach Anspruch 1, dadurch gekennzeichnet, daß es 0,05 bis 5 Gew.-% der Leukobase und 0,01 bis 2 Gew.-% der Verbindung der Formel I enthält.

**6.** Photopolymerisierbares Gemisch nach Anspruch 1, dadurch gekennzeichnet, daß der Photoinitiator eine heterocyclische Verbindung mit 2 bis 5 anellierten Ringen und mindestens einem Stickstoffatom als Heteroatom ist.

**7.** Photopolymerisierbares Gemisch nach Anspruch 6, dadurch gekennzeichnet, daß der Photoinitiator ein Chinolin-, Chinoxalin-, Phenazin- oder Acridinderivat ist.

**8.** Photopolymerisierbares Gemisch nach Anspruch 1, dadurch gekennzeichnet, daß das polymere Bindemittel wasserunlöslich und in wäßrig-alkalischen Lösungen löslich ist.

**9.** Photopolymerisierbares Gemisch nach Anspruch 7, dadurch gekennzeichnet, daß das polymere Bindemittel eine Säurezahl von 50 bis 350 aufweist.

**10.** Photopolymerisierbares Aufzeichnungsmaterial mit einem Schichtträger und einer photopolymerisierbaren Schicht, die als wesentliche Bestandteile

a) ein polymeres Bindemittel,

b) eine Verbindung mit mindestens einer endständigen ethylenischen Doppelbindung und einem Siedepunkt bei Normaldruck oberhalb 100° C, die durch radikalisch initiierte Polymerisation ein Polymeres zu bilden vermag,

c) einen Photoinitiator und

d) die Leukobase eines Triarylmethanfarbstoffs

enthält, dadurch gekennzeichnet, daß die Schicht zusätzlich ein photochromes Spiro-indolino-benzopyran der allgemeinen Formel I

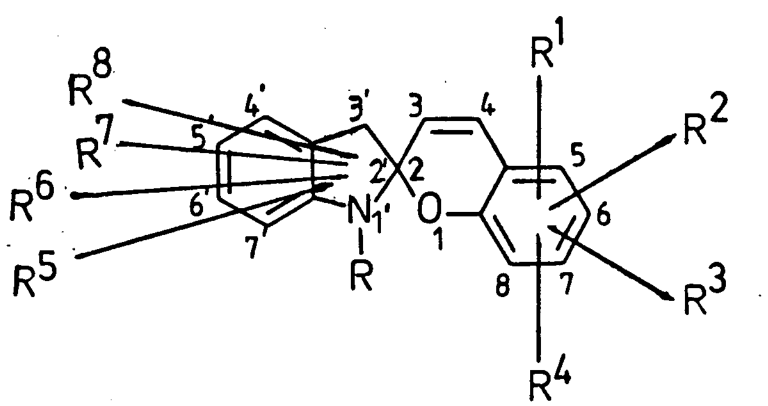

(I)

enthält, worin

| | |
|---|---|
| R | ein Wasserstoffatom oder einen Alkylrest mit 1 bis 16 C-Atomen, |
| $R^1$,$R^2$, $R^3$ und $R^4$ | gleich oder verschieden sind und Wasserstoff- oder Halogenatome, Alkyl- oder Alkoxygruppen mit 1 bis 4 C-Atomen oder Nitrogruppen, |

$R^5$, $R^6$, $R^7$ und $R^8$ gleich oder verschieden sind und Wasserstoff- oder Halogenatome, Nitro-, Amino-gruppen, Alkyl- oder Alkoxygruppen mit 1 bis 5-C-Atomen oder Arylgruppen mit 6 bis 10 C-Atomen

bedeuten.

**11.** Aufzeichnungsmaterial nach Anspruch 10, dadurch gekennzeichnet, daß der Schichtträger eine Oberfläche aus Kupfer oder einer Kupferlegierung hat.

**12.** Verfahren zur Aufzeichnung von Reliefbildern, dadurch gekennzeichnet, daß man ein photopolymerisierbares Aufzeichnungsmaterial gemäß Anspruch 10 bildmäßig belichtet, die Richtigkeit der Belichtung anhand des entstandenen farbigen Bilds prüft und dann die unbelichteten Bereiche der photopolymerisierbaren Schicht auswäscht.

**Claims**

**1.** Photopolymerizable composition which contains, as the essential constituents,

a) a polymeric binder;

b) a compound having at least one terminal ethylenical double bond and a boiling temperature, at standard pressure, or above 100 ° C, and being able to form a polymer by polymerization initiated by a free-radical process;

c) a photoinitiator; and

d) the leuco base of a triarylmethane dye,

characterized in that it additionally contains a photochromic spiro-indolino-benzopyran of the general formula I

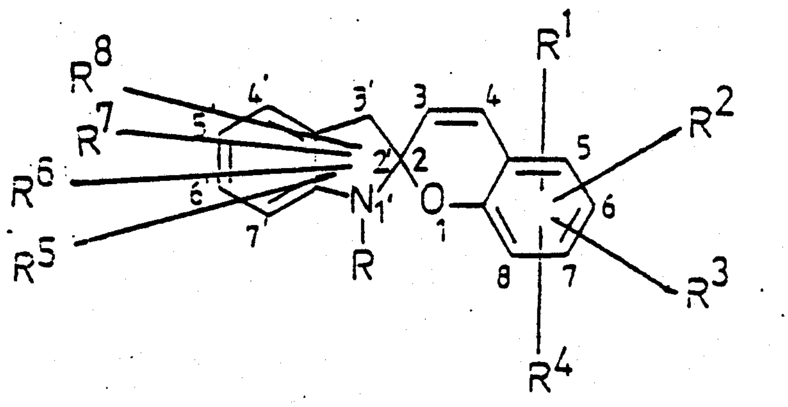

(I)

wherein

| | |
|---|---|
| R | denotes a hydrogen atom or a $C_1$ to $C_{16}$ alkyl group, |
| $R^1$,$R^2$,$R^3$ and $R^4$ | are identical or different and denote hydrogen or halogen atoms, $C_1$ to $C_4$ alkyl or alkoxy groups or nitro groups; |
| $R^5$,$R^6$,$R^7$ and $R^8$ | are identical or different and denote hydrogen or halogen atoms, nitro or amino groups, $C_1$ to $C_5$ alkyl or alkoxy groups or $C_6$ to $C_{10}$ aryl groups. |

**2.** A photopolymerizable composition as in Claim 1, which contains a compound of the formula I, where at least one of the groups $R^1$, $R^2$, $R^3$ and $R^4$ is a nitro group.

**3.** A photopolymerizable composition as in Claim 1, which contains a compound of the formula I, where three of the groups $R^5$, $R^6$, $R^7$ and $R^8$ are methyl groups.

**4.** A photopolymerizable composition as in Claim 1, wherein the leuco base is a tris-(4-dialkylaminophenyl)-methane.

**5.** A photopolymerizable composition as in Claim 1, which contains 0.05 to 5.0 percent by weight of the leuco base and 0.01 to 2.0 percent by weight of the compound of the formula I.

**6.** A photopolymerizable composition as in Claim 1, wherein the photoinitiator is a heterocyclic compound having 2 to 5 fused rings and at least one nitrogen atom as a heteroatom.

**7.** A photopolymerizable composition as in Claim 6, wherein the photoinitiator is a derivative of quinoline, quinoxaline, phenazine or acridine.

**8.** A photopolymerizable composition as in Claim 1, wherein the polymeric binder is insoluble in water and soluble in aqueous-alkaline solutions.

**9.** A photopolymerizable composition as in Claim 7, wherein the Polymeric binder has an acid number of 50 to 350.

**10.** Photopolymerizable recording material comprising a layer support and a photopolymerizable layer which contains, as the essential constituents,

a) a polymeric binder;

b) a compound having at least one terminal ethylenical double bond and a boiling temperature, at standard pressure, of above 100 °C, and being able to form a polymer by polymerization initiated by a free-radical process;

c) a photoinitiator; and

d) the leuco base of a triarylmethane dye,

wherein said layer additionally contains a photochromic spiro-indolino-benzopyran of the general formula I

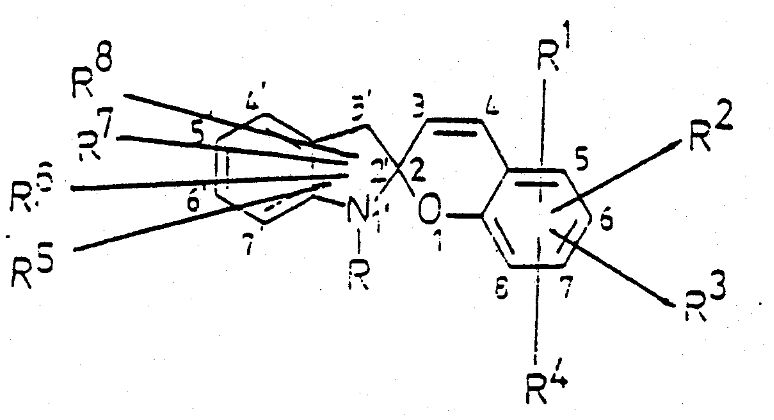

(I)

in which

| | |
|---|---|
| R | denotes a hydrogen atom or a $C_1$ to $C_{16}$ alkyl group, |
| $R^1$,$R^2$,$R^3$ and $R^4$ | are identical or different and denote hydrogen or halogen atoms, $C_1$ to $C_4$ alkyl or alkoxy groups or nitro groups; |
| $R^5$,$R^6$,$R^7$ and $R^8$ | are identical or different and denote hydrogen or halogen atoms, nitro or amino groups, $C_1$ to $C_5$ alkyl or alkoxy groups or $C_6$ to $C_{10}$ aryl groups. |

**11.** A recording material as in Claim 10, wherein one surface of the layer support is copper or a copper alloy.

**12.** Process for recording relief images, in which a photopolymerizable recording material as claimed in Claim 10 is imagewise exposed, the correctness of the exposure is checked by means of the colored image obtained and the unexposed portions of the photopolymerizable layer are then washed out.

**Revendications**

**1.** Composition photopolymérisable qui contient, en tant que composants essentiels

a) un liant polymère;

b) un composé comportant au moins une double liaison éthylénique terminale et ayant un point d'ébullition de plus de 100 °C sous la pression normale, qui permet de former un polymère par

polymérisation déclenchée par des radicaux libres;
c) un photo-initiateur et
d) la leucobase d'un colorant triarylméthane,
caractérisée en ce qu'elle contient en outre un spiroindolinobenzopyranne photochrome de formule générale I

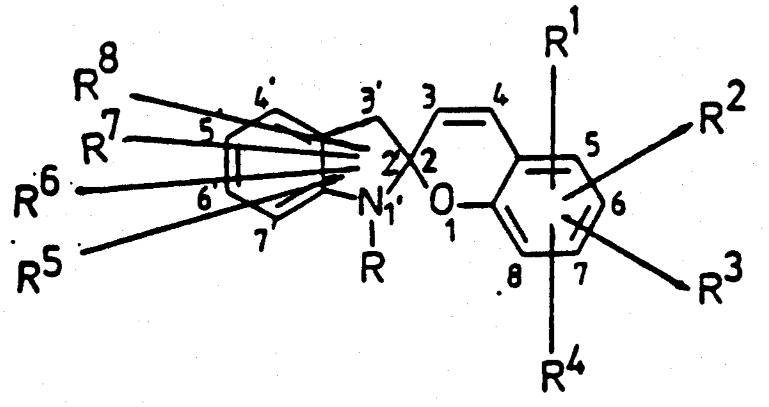

(I)

dans laquelle

| | |
|---|---|
| R | représente un atome d'hydrogène ou un radical alkyle ayant de 1 à 16 atomes de carbone; |
| $R^1$, $R^2$, $R^3$ et $R^4$ | sont identiques ou différents et représentent des atomes d'hydrogène ou d'halogène, des groupes alkyle ou alcoxy ayant de 1 à 4 atomes de carbone ou le groupe nitro; |
| $R^5$, $R^6$, $R^7$ et $R^8$ | sont identiques ou différents et représentent des atomes d'hydrogène ou d'halogène, le groupe nitro ou amino, des groupes alkyle ou alcoxy ayant de 1 à 5 atomes de carbone, ou des groupes aryle ayant de 6 à 10 atomes de carbone. |

**2.** Composition photopolymérisable selon la revendication 1, caractérisée en ce qu'elle contient un composé de formule I dans lequel au moins l'un des radicaux $R^1$, $R^2$, $R^3$ et $R^4$ est le groupe nitro.

**3.** Composition photopolymérisable selon la revendication 1, caractérisée en ce qu'elle contient un composé de formule I dans lequel trois des radicaux $R^5$, $R^6$, $R^7$ et $R^8$ sont des groupes méthyle.

**4.** Composition photopolymérisable selon la revendication 1, caractérisée en ce que la leucobase est un tris-(4-dialkylaminophényl)méthane.

**5.** Composition photopolymérisable selon la revendication 1, caractérisée en ce qu'elle contient de 0,05 à 5 % en poids de la leucobase et de 0,01 à 2 % en poids du composé de formule I.

**6.** Composition photopolymérisable selon la revendication 1, caractérisée en ce que le photo-initiateur est un composé hétérocyclique comportant de 2 à 5 cycles condensés et au moins 1 atome d'azote en tant qu'hétéroatome.

**7.** Composition photopolymérisable selon la revendication 6, caractérisée en ce que le photo-initiateur est un dérivé de quinoléine, quinoxaline, phénazine ou acridine.

**8.** Composition photopolymérisable selon la revendication 1, caractérisée en ce que le liant polymère est insoluble dans l'eau et soluble dans des solutions aqueuses-alcalines.

**9.** Composition photopolymérisable selon la revendication 7, caractérisée en ce que le liant polymère présente un indice d'acide de 50 à 350.

**10.** Matériau de reprographie photopolymérisable, comportant un support de couche et une couche photopolymérisable qui contient, en tant que composants essentiels

a) un liant polymère;

b) un composé comportant au moins une double liaison éthylénique terminale et ayant un point d'ébullition de plus de 100 °C sous la pression normale, qui permet de former un polymère par polymérisation déclenchée par des radicaux libres;

c) un photo-initiateur et

d) la leucobase d'un colorant triarylméthane,

caractérisé en ce que la couche contient en outre un spiroindolinobenzopyranne photochrome de formule générale I

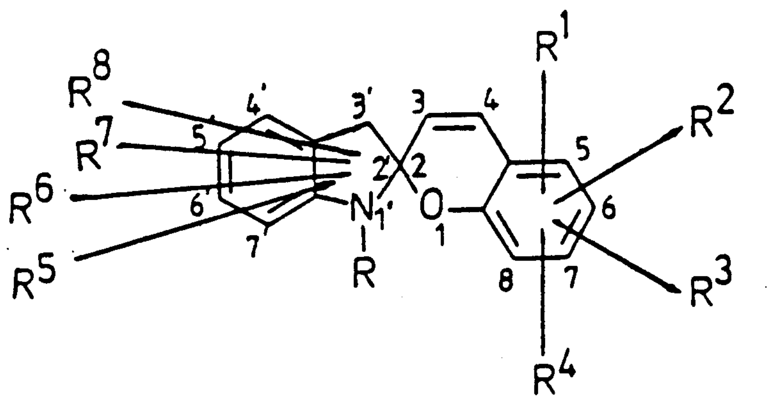

(I)

dans laquelle

| | |
|---|---|
| R | représente un atome d'hydrogène ou un radical alkyle ayant de 1 à 16 atomes de carbone; |
| $R^1$, $R^2$, $R^3$ et $R^4$ | sont identiques ou différents et représentent des atomes d'hydrogène ou d'halogène, des groupes alkyle ou alcoxy ayant de 1 à 4 atomes de carbone ou le groupe nitro; |
| $R^5$, $R^6$, $R^7$ et $R^8$ | sont identiques ou différents et représentent des atomes d'hydrogène ou d'halogène, le groupe nitro ou amino, des groupes alkyle ou alcoxy ayant de 1 à 5 atomes de carbone, ou des groupes aryle ayant de 6 à 10 atomes de carbone. |

**11.** Matériau de reprographie selon la revendication 10, caractérisé en ce que le support de couche a une surface de cuivre ou d'un alliage de cuivre.

**12.** Procédé pour la reproduction d'images en relief, caractérisé en ce que l'on expose selon l'image un matériau de reprographie photopolymérisable selon la revendication 10, on contrôle l'exactitude de l'insolation à l'aide de l'image colorée résultante et on élimine ensuite par lavage les zones non exposées de la couche photopolymérisable.

FIG 1

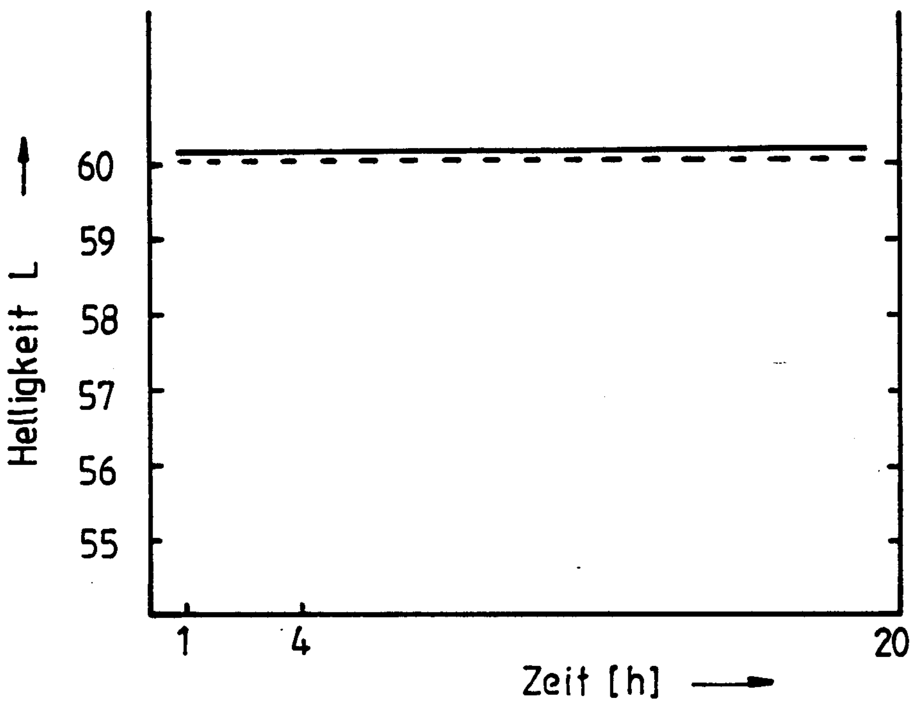
Helligkeit L
60
59
58
57
56
55
1
4
20
Zeit [h]

FIG 2

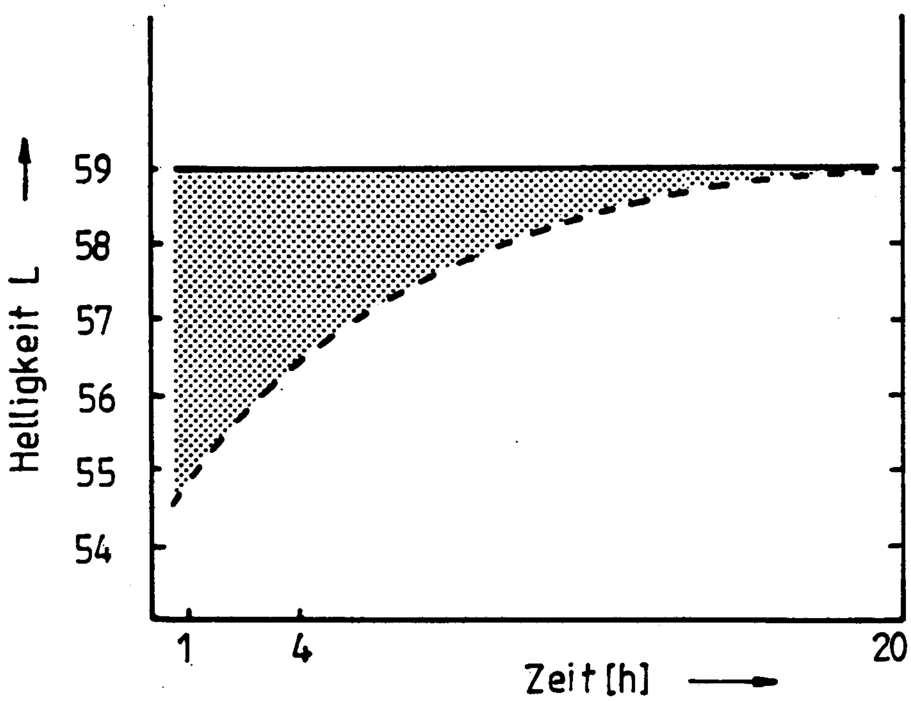
Helligkeit L
59
58
57
56
55
54
1
4
20
Zeit [h]

FIG 3

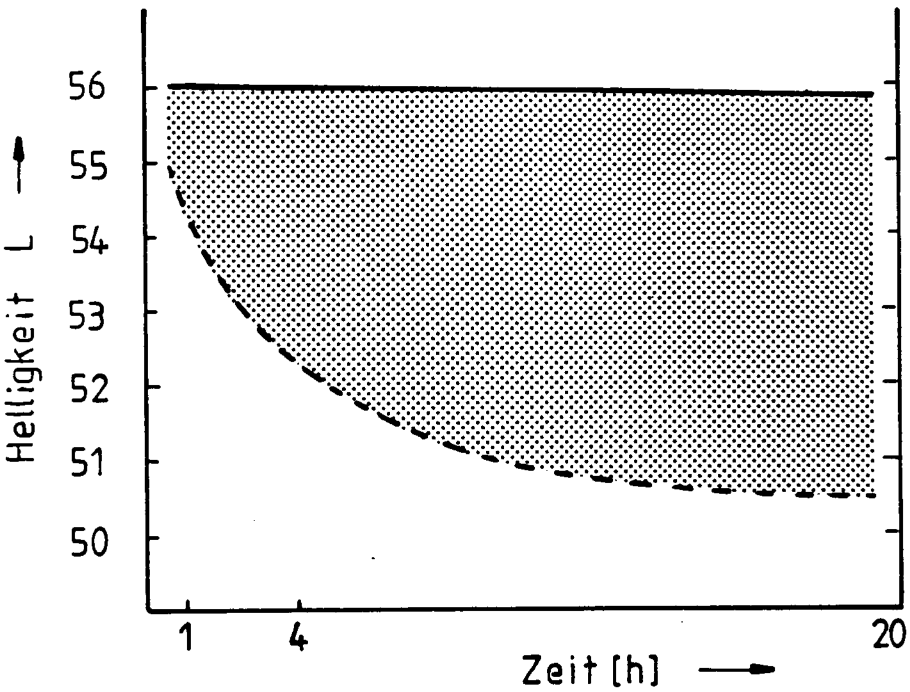
56
55
54
53
52
51
50
Helligkeit L
1
4
20
Zeit [h]

FIG 4

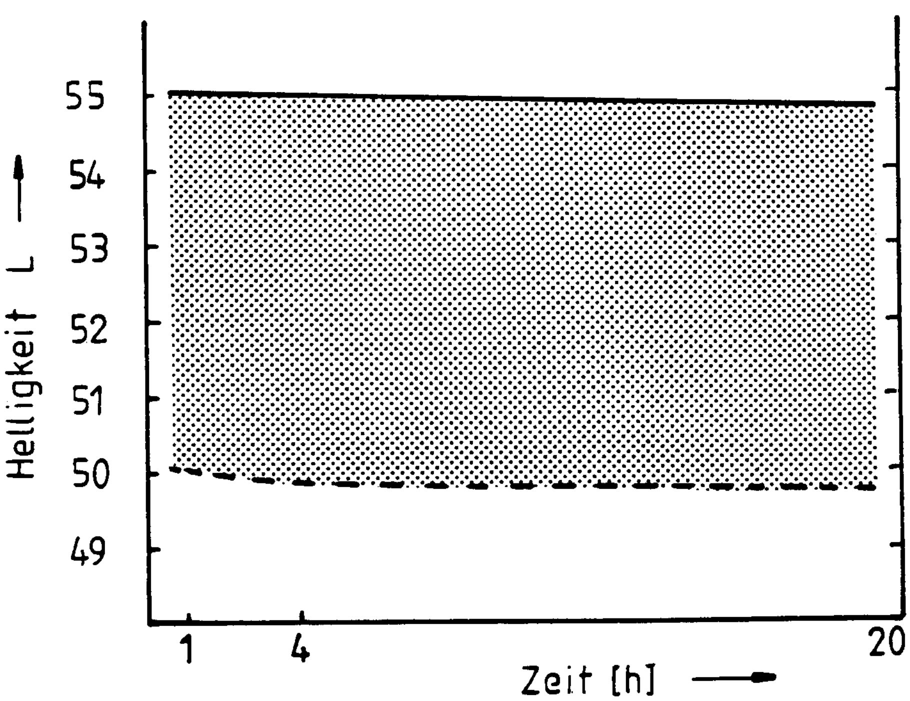
55
54
53
52
51
50
49
Helligkeit L
1
4
20
Zeit [h]